**Europäisches Patentamt**

**European Patent Office**

**Office européen des brevets**

(11) Numéro de publication: **0 390 680**
**A1**

## (12) DEMANDE DE BREVET EUROPEEN

(21) Numéro de dépôt: **90400844.8**

(51) Int. Cl.5: **G01R 19/165**

(22) Date de dépôt: **28.03.90**

(30) Priorité: **28.03.89 FR 8904005**

(43) Date de publication de la demande:
**03.10.90 Bulletin 90/40**

(84) Etats contractants désignés:
**AT BE CH DE DK ES FR GB GR IT LI LU NL SE**

(71) Demandeur: **ELECTRICITE DE FRANCE**
**Service National**
**2, rue Louis Murat**
**F-75008 Paris(FR)**

(72) Inventeur: **Dubarry, Pierre**
**9 allée de l'Auvergne**
**F-31770 Colomiers(FR)**
Inventeur: **Savary, Pierre**
**34 rue du Petit Tour**
**F-87000 Limoges(FR)**

(74) Mandataire: **Moncheny, Michel et al**
**c/o Cabinet Lavoix 2 Place d'Estienne**
**d'Orves**
**F-75441 Paris Cedex 09(FR)**

(54) **Procédé et dispositif de mesure de la tension du secteur.**

(57) Dispositif de mesure de la tension du secteur, caractérisé en ce qu'il comporte des moyens (5) pour établir au moins un seuil de fonctionnement et au m oins un seuil de dégagement, des moyens (7) pour mesurer la valeur efficace de la tension du secteur, des moyens (11) pour comparer cette valeur mesurée avec un seuil de fonctionnement programmé, des moyens pour mémoriser la date de l'instant auquel la valeur mesurée devient inférieure ou supérieure au seuil programmé, des moyens pour mesurer la durée pendant laquelle la valeur de tension mesurée reste inférieure ou supérieure à un seuil de dégagement et des moyens pour calculer la valeur moyenne de la tension pendant la durée d'une anomalie, des moyens de comparaison de la durée de l'anomalie à un seuil de durée quand la valeur mesurée franchit le seuil de dégagement dans le sens décroissant ou le seuil de fonctionnement dans le sens croissant et des moyens de calcul de la valeur efficace moyenne du phénomène si la durée mesurée est supérieure au seuil de durée.

EP 0 390 680 A1

FIG.1

EP 0 390 680 A1

La présente invention est relative aux dispositifs de surveillance du réseau de distribution d'énergie électrique et se rapporte plus particulièrement aux dispositifs de détection des chutes et élévations de la tension électrique du réseau et de mémorisation des informations relatives à chacun de ces évènements.

On connait des dispositifs de surveillance du réseau de distribution électrique permettant notamment d'indiquer l'importance d'une baisse de tension du réseau électrique, capables de fournir en pourcentage la valeur réelle de la tension par rapport à la tension nominale.

On connait en particulier, d'après la demande de brevet européen 163 282 un dispositif dans lequel on mesure la valeur de crête de la tension à chaque demi-période et, on calcule ensuite la valeur moyenne des tensions de crête de 32 demi-périodes successives afin de détecter les baisses de tension ou les surtensions.

Cette surveillance de la tension de crête du réseau ne répond pas aux besoins des usagers du réseau qui désirent connaître la puissance électrique qui reste disponible lors des à-coups de tension brefs.

L'invention vise à créer un dispositif de surveillance du réseau qui fournisse une information utile du point de vue énergétique aux usagers.

Elle a pour objet un dispositif de mesure de la tension du secteur, caractérisé en ce qu'il comporte des moyens pour établir au moins un seuil de fonctionnement et au moins un seuil de dégagement, des moyens pour mesurer la valeur efficace de la tension du secteur, des moyens pour comparer cette valeur mesurée avec un seuil de fonctionnement programmé, des moyens pour mémoriser la date de l'instant auquel la valeur mesurée devient inférieure ou supérieure au seuil programmé, des moyens pour mesurer la durée pendant laquelle la valeur de tension mesurée reste inférieure ou supérieure à un seuil de dégagement et des moyens pour calculer la valeur moyenne de la tension pendant la durée d'une anomalie, des moyens de comparaison de la durée de l'anomalie à un seuil de durée quand la valeur mesurée franchit le seuil de dégagement dans le sens décroissant ou le seuil de fonctionnement dans le sens croissant et des moyens de calcul de la valeur efficace moyenne du phénomène si la durée mesurée est supérieure au seuil de durée.

Le fait de détecter et surveiller la valeur efficace moyenne de la tension fournit une réponse adaptée aux besoins des usagers lors des à-coups de tension brefs.

L'invention sera mieux comprise à l'aide de la description qui va suivre, donnée uniquement à titre d'exemple et faite en se référant aux dessins annexés, sur lesquels :

- la Fig. 1 est un schéma synoptique d'un dispositif de détection des chutes de tension suivant un mode de réalisation de l'invention ;

- la Fig. 2 est un schéma électrique du circuit d'adaptation de signal entrant dans la construction du dispositif suivant l'invention ;

- les Fig 3, 4 et 5 sont des schémas plus détaillés du circuit du processeur du dispositif suivant l'invention ; et

- les Fig. 6 à 8 sont des schémas électriques du circuit d'alimentation du dispositif suivant l'invention.

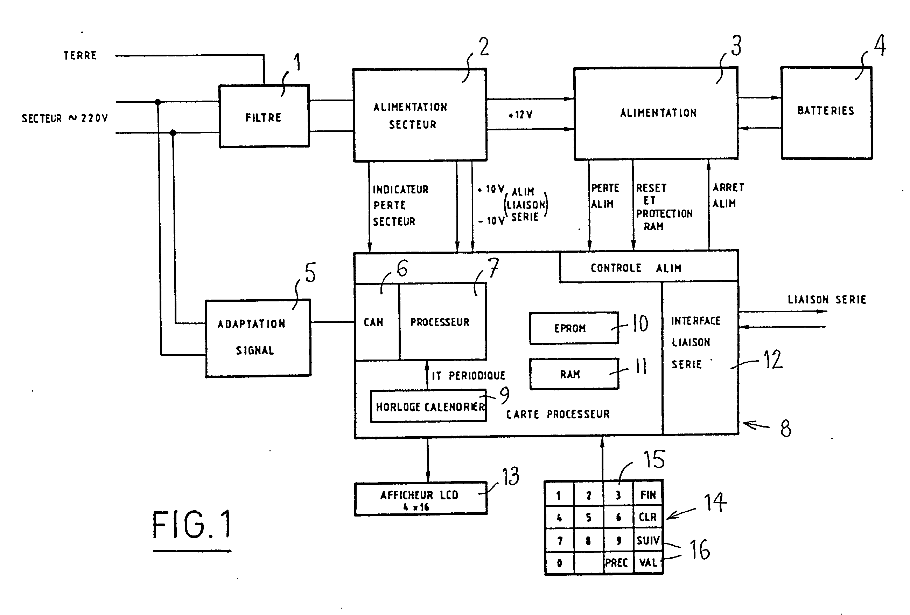

Ce dispositif représenté à la Fig. 1 comporte principalement un filtre 1 dont les bornes d'entrée sont connectées au secteur à surveiller d'une part et à la terre d'autre part.

Le rôle du filtre 1 est d'éviter la réjection des bruits générés par le circuit disposé immédiatement en aval du filtre 1 et qui va maintenant être décrit.

Il s'agit d'un circuit d'alimentation secteur 2 connecté aux sorties du filtre et destiné à élaborer à partir du secteur alternatif des tensions continues.

Dans le présent exemple, le circuit 2 élabore une tension de +12V destinée à être appliquée à un circuit d'alimentation à basse tension 3.

Il élabore en outre des tensions de ± 10V pour alimenter les interfaces de la liaison série du dispositif.

Il génère enfin un signal de perte de secteur destiné à être appliqué au processeur entrant dans la construction du dispositif, lorsque la tension du secteur tombe en-dessous d'une valeur de l'ordre de 45V pour une tension nominale de 220V.

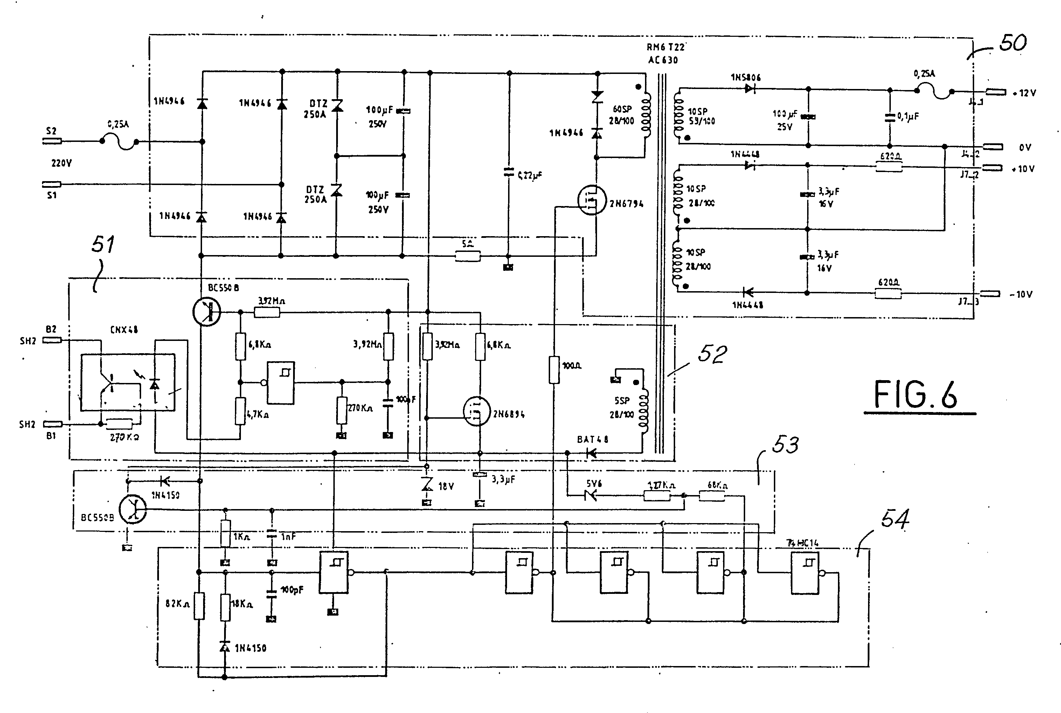

Le circuit d'alimentation basse tension 3 alimenté par la tension continue délivrée par le circuit d'alimentation secteur 2 assure la charge lente à courant constant de batteries 4 comprenant des batteries primaires, des moyens pour la génération de tensions de + 5V et - 5V, et une batterie secondaire qui seront décrits en référence aux Fig. 6 à 8.

En l'absence de l'alimentation fournie par le circuit d'alimentation secteur 2, les batteries primaires prennent le relais pour générer les tensions de + 5V et - 5V.

La batterie secondaire est maintenue en charge lente à partir de la tension de +5V.

Les batteries primaires assurent la garde de marche du processeur que comporte le dispositif après une coupure du secteur.

Cette garde de marche est utilisée sur environ 1 minute après la coupure, puis le processeur

2

commande l'interruption.

L'autonomie des batteries primaires permet d'assurer le fonctionnement sans recharge pour quelques dizaines de coupures de moins d'une minute se succédant à brefs intervalles.

La batterie secondaire assure le fonctionnement de l'horloge calendrier et la conservation des données dans une mémoire RAM pendant environ 72 heures sans recharge.

Le dispositif représenté à la Fig. 1 comporte en outre un circuit 5 d'adaptation de signal connecté au secteur à surveiller.

Ce circuit d'adaptation de signal est destiné à convertir la tension alternative du secteur en une tension continue proportionnelle à sa valeur efficace.

La sortie du circuit d'adaptation 5 est connecté à l'entrée d'un convertisseur analogique-numérique 6 d'un processeur 7.

Le convertisseur analogique-numérique 6 dispose d'une fonction de mise à l'échelle automatique utilisant une tension de référence.

Le processeur 7 fait partie d'une carte numérique 8.

Le processeur 7 est en fait un microprocesseur de type 68 HC11 fabriqué et vendu par la société MOTOROLA qui intègre autour de sa structure de processeur à huit bits les fonctions suivantes : la conversion analogique-numérique permettant la numérisation du signal de sortie du circuit d'adaptation 5, une liaison série asynchrone, des portes d'entrée-sortie, des signaux d'interruption.

La carte 8 comporte en outre une horloge calendrier 9 générant en outre un signal d'interruption périodique appliqué au microprocesseur 7, destiné à activer l'acquisition de la valeur efficace du signal, une mémoire EPROM 10 contenant le programme de fonctionnement du dispositif, une mémoire RAM 11 de mémorisation des variables et des données, un dispositif assurant la protection de la mémoire RAM 11 et de l'horloge calendrier 9 en cas de chute de la tension d'alimentation délivrée par le circuit d'alimentation 3, un circuit 12 d'interface électrique de liaison série, un dispositif de contrôle d'un afficheur 13 et d'un clavier 14 associés à la carte de processeur 8.

L'afficheur 13 est du type à écran à cristaux liquides LCD de quatre lignes et seize caractères et le clavier 14 est un clavier à seize touches comprenant dix touches numériques 15 et cinq touches de fonctions 16.

Les touches de fonctions 16 sont les suivantes :

FIN = fin de phase
CLR = effacement d'un chiffre saisi
VAL = validation d'une donnée
SUIV = résultat suivant
PREC = résultat précédent

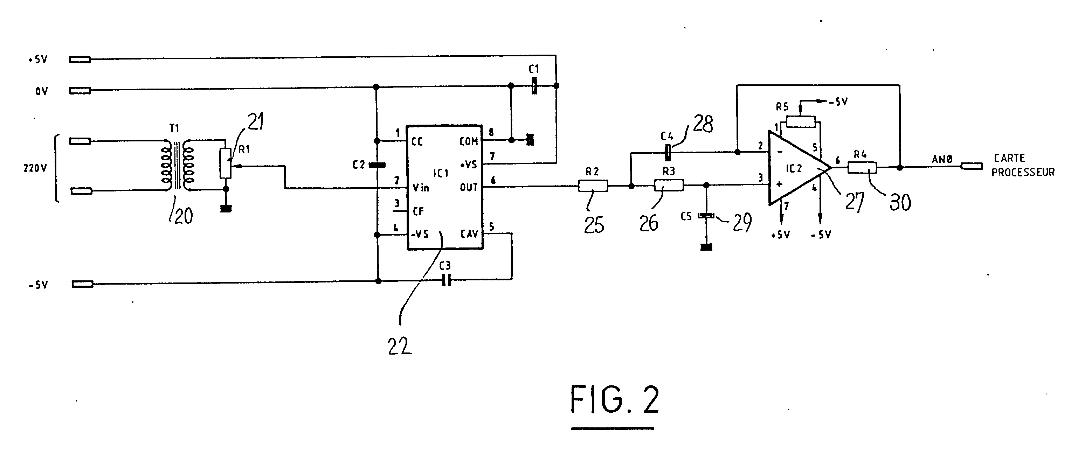

Le circuit 5 d'adaptation du signal représenté à la Fig. 2 comporte principalement un transformateur abaisseur de tension 20 dont le secondaire est connecté aux bornes d'un potentiomètre 21, le curseur de celui-ci étant relié à une entrée d'un convertisseur RMS/DC de tension efficace en tension continue 22, constitué par un circuit intégré AD 736.

La sortie du convertisseur de tension 22 est connecté par l'intermédiaire de deux résistances 25, 26 branchées en série, à l'entrée non-inverseuse d'un amplificateur opérationnel 27.

Le point commun des résistances 25, 26 est connecté à l'entrée inverseuse de l'amplificateur 27, par l'intermédiaire d'un condensateur 28.

Par ailleurs, un condensateur 29 est connecté entre l'entrée non inverseuse de l'amplificateur 27 et la masse.

La sortie de l'amplificateur est connecté par l'intermédiaire d'une résistance 30 à la carte microprocesseur du dispositif.

L'amplificateur opérationnel 27 est par exemple du type LE351 et il assure la fonction de filtre passe-bas et d'élimination des ondulations du signal sortant du circuit 22.

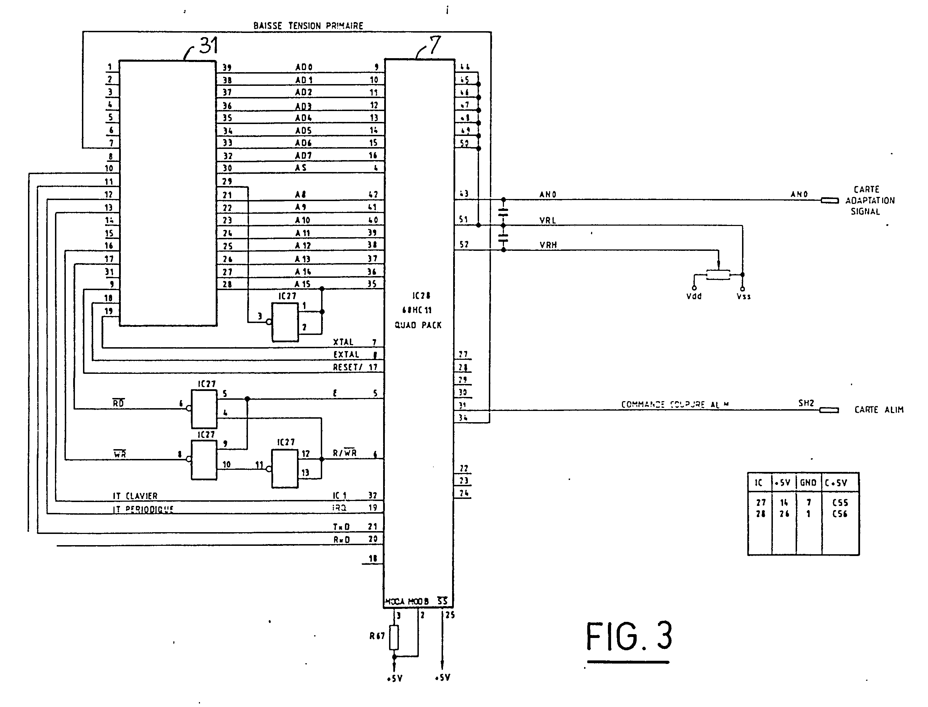

La carte 8 est représentée aux Fig. 3 à 5.

Elle comporte principalement le microprocesseur 7 connecté par une de ses entrées à la sortie du circuit 5 d'adaptation de signal représenté à la Fig. 2.

Il s'agit dans le présent exemple d'un microprocesseur MC68HC11A1 de la société MOTOROLA auquel est associé le convertisseur analogique-numérique 6 (Fig.1).

Le microprocesseur 7 assure en outre la gestion de l'alimentation du dispositif en fonction de l'état des circuits d'alimentation 2 et 3 (Fig.1)

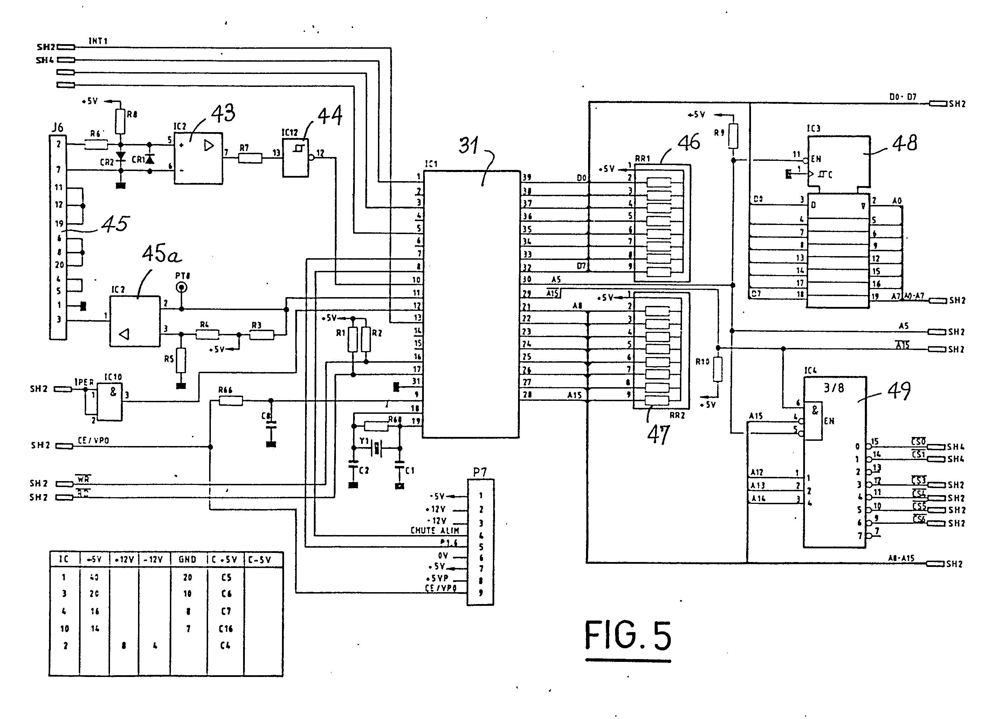

Il est relié à un circuit 31 de connexion avec la partie du dispositif représenté à la Fig. 5.

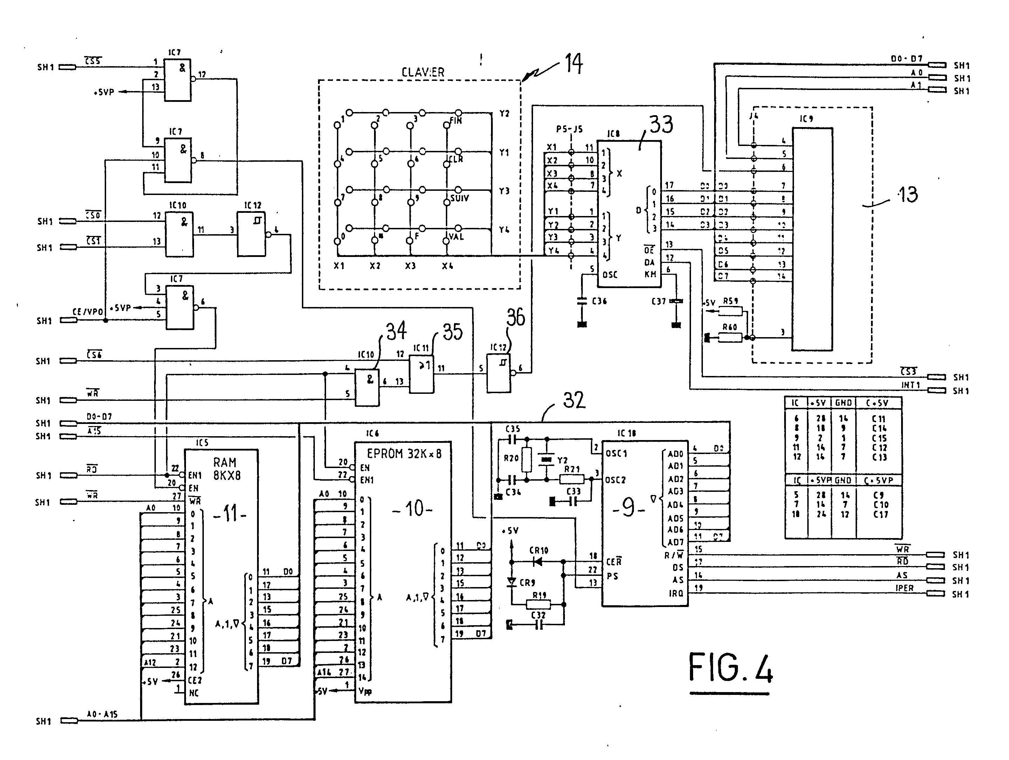

La partie du processeur représentée à la Fig. 4 comporte la mémoire RAM 11 qui dans le présent exemple est une mémoire de 8 K octets du type HM6264LP de la société HITACHI, la mémoire EPROM 10 qui est une mémoire de 32 K octets du type D27256 de la société INTEL, l'horloge 9 qui est un circuit MC 14818 P de la société MOTOROLA, les signaux de sortie de ces circuits étant connectés à un bus commun 32.

Le clavier 14 est connecté, à l'afficheur 13 par l'intermédiaire d'un décodeur de clavier 33 du type 74C922 de NSC.

L'afficheur 13 est connecté aux mémoires RAM et EPROM 11 et 10 par l'intermédiaire de trois circuits 34, 35, 36 parmi lesquels les circuits 34 et 35 sont des ensembles de quatre portes à deux entrées 74 HC08 et 74HC32 de la société TEXAS et le circuit 36 est un ensemble de six inverseurs 74HC14 de cette même société.

L'horloge 9 est alimentée en tension à partir du circuit d'alimentation 3 (Fig.1) mais également à partir de la batterie auxiliaire lors d'une coupure d'alimentation.

Les circuits 9, 10, 11, 13, 33 sont connectés au bus de données et d'adresse du microprocesseur 7.

La partie du circuit du microprocesseur représentée à la Fig. 5 comporte principalement le circuit 31 de connexion avec le circuit de la Fig. 3 dont une entrée est connectée par un double amplificateur 43 et un ensemble d'inverseurs 44 à un connecteur 45 et dont une sortie est connectée à ce même connecteur par un autre double amplificateur 45a.

Les circuits 43, 44 et 45 assurent les interfaces électriques de la liaison série RS232 simplifiée.

Par ailleurs, le circuit 31 est relié à des réseaux de résistances 46, 47 ainsi qu'à un ensemble de bascules 48 assurant le démultiplexage des adresses par rapport aux données et à un décodeur d'adresses 49.

L'ensemble de bascules 48 est avantageusement un ensemble de huit bascules à trois états du type 74HC373 de la société TEXAS tandis que le décodeur 49 est un décodeur 3/8 du type 74HC138 de cette même société.

Les réseaux de résistances 46 et 47 assurent un niveau électrique sur les bus de données et d'adresses du microprocesseur.

Sur les Fig. 6 à 8, les principaux circuits sont représentés par des rectangles en trait mixte.

Le circuit représenté à la Fig.6 comporte un circuit 50 fournissant des tensions de +12V, +10V et -10V.

Le circuit 50 est connecté à un circuit 51 de protection en sous-tension et en puissance et destiné à générer sur ses sorties B1, B2, un signal de bon fonctionnement.

Un circuit ballast 52 assure l'alimentation de circuits de régulation et de protection.

La régulation en tension est assurée par un circuit 53 et la commande en régulation du circuit 50 est assurée par un circuit de commande 54.

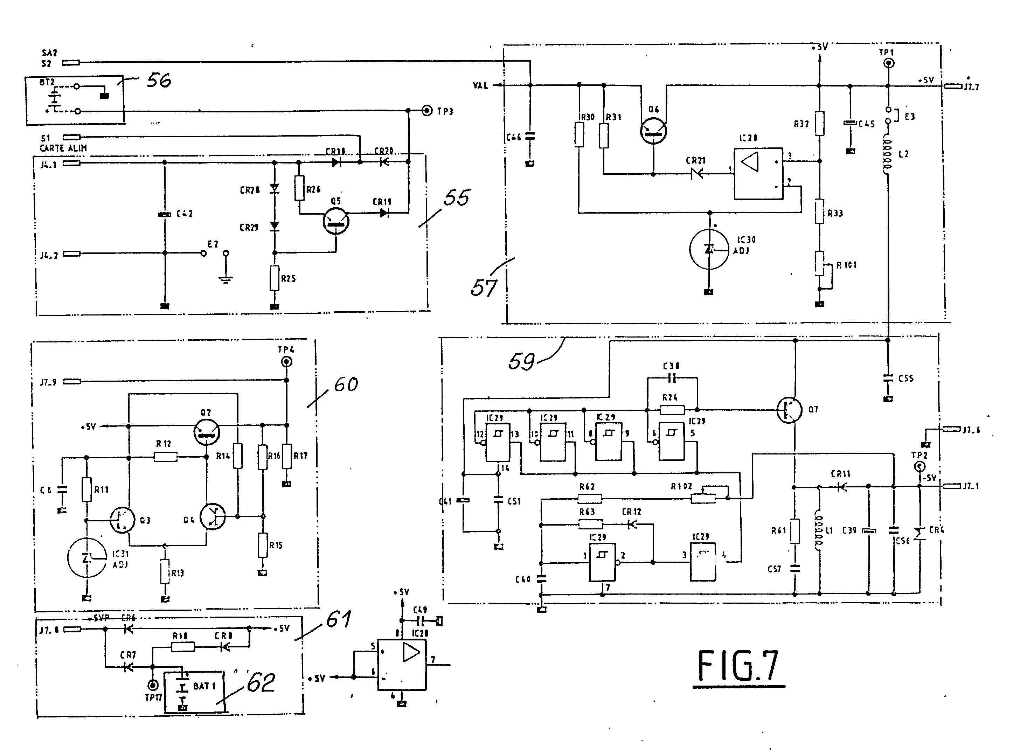

Le circuit représenté à la Fig.7 comporte un circuit 55 qui, à partir de la tension de +12V délivrée par le circuit 50 de la Fig.6 assure la charge d'une batterie primaire ou de fonctionnement 56 qui fait partie des batteries 4 de la Fig.1.

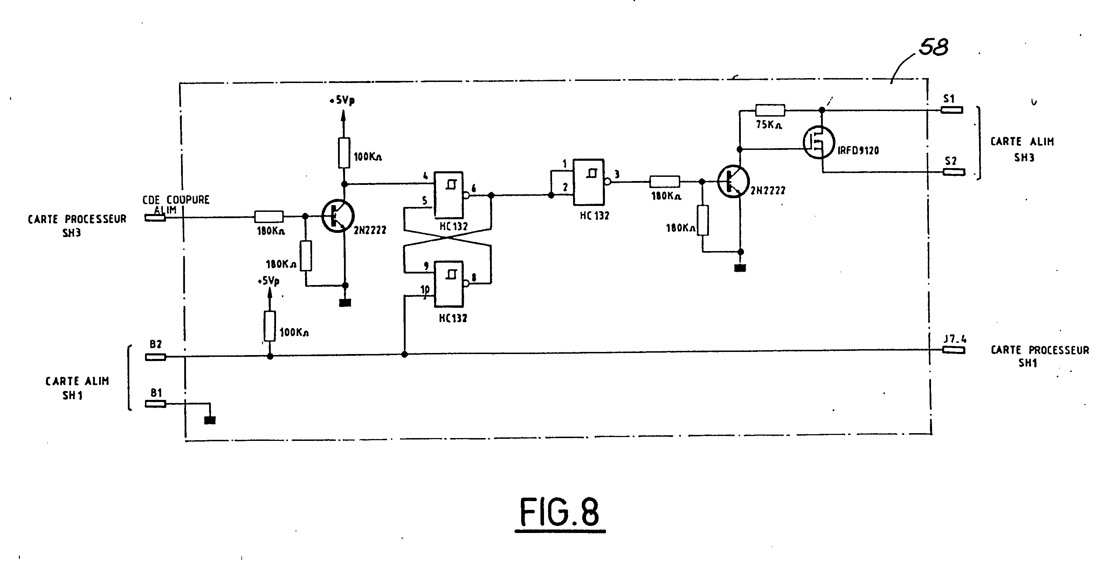

Il comporte en outre un circuit 57 de production d'une tension régulée de + 5V qui est alimentée en tension soit par le circuit 50 de la Fig.6 soit par la batterie primaire 56 par l'intermédiaire d'un circuit interrupteur 58 représenté à la Fig.8 qui est connecté d'une part au circuit 51 et d'autre part au microprocesseur 7.

Le circuit interrupteur 58 est commandé en ouverture par le microprocesseur et en fermeture par le signal de bon fonctionnement délivré par le circuit 51.

Le circuit de la Fig.7 comporte en outre un circuit 59 de production d'une tension de - 5V associé au circuit 57 de production de la tension de + 5V, un circuit 60 de protection des mémoires en cas de baisse de tension de la tension à 5 V, ce circuit étant destiné à engendrer un signal de rétablissement pour le microprocesseur 7.

Il comporte enfin un circuit 61 assurant la charge d'une batterie secondaire ou de sauvegarde 62 à partir de la tension à 5 V.

Le fonctionnement du dispositif repose sur trois phases à savoir le paramètrage des mesures, le lancement des mesures, le relevé des mesures.

Le paramètrage permet de mettre à jour si nécessaire l'horloge-calendrier 9, de définir le seuil de tension en volts, de définir un seuil de durée en centièmes de seconde.

Au cours de la phase de mesure, le dispositif suivant l'invention mémorise les chutes de tension en-dessous du seuil de tension ayant une durée supérieure au seuil de durée.

La valeur efficace moyenne durant la chute est également mémorisée, avec la date de début de la chute.

Si la tension est descendue en-dessous du seuil de fonctionnement de l'alimentation du dispositif, la valeur efficace moyenne est considérée comme étant nulle.

4

La mesure est lancée par l'opérateur et est arrêtée soit par l'opérateur, soit quand la mémoire RAM 11 est pleine.

Au cours de la phase de relevé, l'opérateur peut visualiser pas à pas sur l'afficheur 13 ou éditer en continu sur une liaison série, par l'intermédiaire de l'interface 12, l'ensemble des résultats y compris les paramètres ayant servi à la mesure et qui sont :
- l'identificateur
- les seuils de tension et de durée
- les dates de début et de fin de la mesure.

Chacune des chutes de tension entraîne la mémorisation :
- de la date de début
- de la durée
- de la valeur efficace moyenne.

On donne ci-après une description du logiciel destiné à assurer le fonctionnement du dispositif suivant l'invention.

Cependant, avant de passer à la description du logiciel proprement dit, il y a lieu de préciser que le dispositif peut fonctionner soit en témoin de la continuité de la tension du secteur ou TECT, soit en indicateur de qualité de service ou IQS.

Certaines des fonctions du dispositif sont communes aux deux modes précités.

## DESCRIPTION DU LOGICIEL

Le logiciel regroupe les fonctionnalités du TECT et de l'IQS et certaines fonctions sont communes, d'autres sont spécifiques au logiciel activé. Un seul des deux logiciels est actif à un moment donné.

### FONCTIONS COMMUNES

#### Mise sous tension

Si une phase de mesure était en cours, reprise de la mesure.

Si non, après les initialisations du matériel et des variables, présentation d'un menu permettant de choisir entre le fonctionnement en TECT ou en IQS.

#### Menu général

Il permet à l'opérateur d'activer :
- le paramètrage de la mesure
- la mesure
- la relève des résultats.

#### Acquisition

Active en cours de phase mesure.

Sous interruption périodique, générée par l'horloge calendrier, à une période d'environ 2 ms (f = 512 Hz) pour TECT, 4 ms pour IQS (256 Hz).
- conversion analogique-numérique du signal
- lecture de la date
- test de l'état de l'alimentation secteur.

Ces informations sont stockées dans une file circulaire, traitées ensuite par le programme de mesure du dispositif.

#### Fonctions diverses

Sont également communs aux deux programmes tous les utilitaires permettant :
- l'affichage du texte et valeurs
- la saisie des paramètres
- les choix dans les menus, le défilement des résultats
- la lecture et la mise à jour de l'horloge calendrier 9
- les éditions.

## FONCTIONS SPECIFIQUES DE L'IQS

### Paramétrage

Outre la mise à jour éventuelle de l'horloge calendrier
- la saisie du seuil de tension et du seuil de durée
- seuil de tension : en millièmes de la tension normale ; le seuil saisi est le seuil de fonctionnement ; le seuil de dégagement lui est supérieur de 10% de la pleine échelle.
- seuil de durée : en heures, minutes, secondes, centièmes de seconde.

### Mesure

Chaque acquisition est traitée successivement.

La mesure de signal est comparée au seuil de tension pour détecter les transitions telles que le passage sous le seuil de fonctionnement, et le passage au-dessus du seuil de dégagement.

L'état de l'alimentation secteur, quand il passe à l'état "alimentation inopérante", déclenche le comptage d'un temps d'environ une minute au bout duquel l'alimentation basse tension est coupée.

La date est utilisée pour dater le début et la fin de la chute de tension.

Si le processeur a coupé son alimentation, la différence de ces deux dates donne la durée de la coupure. Si non, le comptage continu du temps fournit directement l'information.

Durant une chute de tension, une mesure toutes les 10 ms environ est prise en compte et accumulée pour, à la fin de la chute, calculer la valeur efficace moyenne durant la chute. Pour éviter de prendre en compte des mesures lors des transitions quelques demi-périodes, par exemple 40 ms, au début et à la fin de la chute ne sont pas prises en compte.

A la fin de la chute, si sa durée a été supérieure au seuil de durée, on ajoute à la table des mesures :
- la date du début de la chute
- sa durée
- la valeur efficace moyenne durant la chute.

### Relevé des résultats

L'opérateur visualise en pas à pas, ou édite en continu :
- les paramètres de la mesure
- les dates de début et de fin de la mesure
- la table des mesures

## FONCTIONS SPECIFIQUES DE L'IQS

### Paramétrage

Outre la mise à jour éventuelle de l'horloge calendrier,
- saisi du nombre de seuils de tensions et des valeurs de ces seuils
- saisi du nombre de seuils de durée et valeurs de ces seuils
- nombre de seuils : sept maximum par catégorie

- seuils de tension : en millièmes de la valeur nominale
- seuils de durée : en heures, minutes, secondes, centièmes de seconde.

Mesure

Pour chacun des seuils de tension paramétrés, le même algorithme pour la mesure de durée que celui du TECT est utilisé.

Par contre, il n'y a pas de calcul de valeur efficace moyenne durant la chute.

A la fin de la chute par rapport à un seuil de tension déterminé, la durée de cette chute est comparée aux seuils de durée.

Si cette durée est inférieure au seuil minimum, aucune action.

Si non, la comparaison se fait à partir du seuil de durée le plus élevé. Dès que l'on obtient la relation : durée mesurée > seuil de durée, le compteur correspondant à ce seuil de durée et au seuil de tension en cours de traitement est incrémenté.

49 compteurs au maximum sont utilisés.

Relevé des résultats

L'opérateur visualise pas à pas :
- les paramètres de la mesure
- les dates de début et de fin de la mesure
- le contenu de chaque compteur, en précisant ses bornes min et max en seuils de tension et de durée.

Certains des composants entrant dans la construction des circuits représentés aux Fig.2 à 8 sont référencés sur ces figures par leur désignation commerciale.

Les autres composants sont désignés par leur type et leur désignation est reprise dans les tableaux ci-après.

## CIRCUIT D'ALIMENTATION (Fig.6 à 8)

| QTE | CODE | DESIGNATION | REP. | REF. FABRICANT | FABRICANT |
|---|---|---|---|---|---|
| | | RESISTANCES | | | |
| 1 | | 2,7K    2 %    1/8W | R11 | RC  8  U | |
| 2 | | 10 K    2 %    1/8W | R12 | RC  8  U | |
| 1 | | 5,6K    2 %    1/8W | R13 | RC  8  U | |
| 1 | | 5,49K    1%    1/16W | R14 | RS  48  K | |
| 1 | | 5,62K    1%    1/16W | R15 | RS  48  K | |
| 1 | | 3,30K    2 %    1/8W | R16 | RC  8  U | |
| / | | 10 K    2 %    1/8W | R17 | RC  8  U | |
| 1 | | 120    2 %    1/8W | R18 | | |
| | | | | | |
| | | | | | |
| | | | | | |
| | | | | | |
| | | | | | |
| 1 | | 270    2 %    1/8W | R24 | RC  8  U | |
| 1 | | 680    5%    1/4W | R25 | RC  21  U | |
| 1 | | 12    5%    1/4W | R26 | RC  21  U | |
| 1 | | 6,98K    1%    1/16W | R27 | RS  48  K | |
| 1 | | 332    1%    1/16W | R28 | RS  48  K | |
| 1 | | 4,87K    1%    1/16W | R29 | RS  48  K | |
| 1 | | 3,3 K    5%    1/4 W | R30 | RC  21  U | |
| | | | | | |
| 1 | | 1,5 K    5%    1/4 W | R31 | RC  21  U | |
| 1 | | 3,9 K    2 %    1/8 W | R32 | RC  8  U | |
| 1 | | 3,3 K    2 %    1/8 W | R33 | RC  8  U | |
| | | | | | |
| | | | | | |
| 1 | | 33    5%    1/4 W | R61 | RC  21  U | |
| 1 | | 20 K    2 %    1/8 W | R62 | RC  8  U | |
| 1 | | 4,7K    2 %    1/8 W | R63 | RC  8  U | |

| QTE | CODE | DESIGNATION | REP | REF. FABRICANT | FABRICANT |
|---|---|---|---|---|---|
| | | CONDENSATEUR | | | |
| 6 | | 0,1 F 63 V | C8 | CN 73-1 | EUROFARAD |
| 2 | | 470 pF 100V | C38 | CE 72-1 | EUROFARAD |
| 2 | | 22 F 16 V | C39 | CTS 4 E | |
| / | | 470 pF 100V | C40 | CE 72-1 | EUROFARAD |
| / | | 22 F 16 V | C41 | CTS 4 E | |
| 1 | | 1000 F 25 V | C42 | TICO.K | |
| 3 | | 220 F 25 V | C43 | TICO.K | |
| / | | 220 F 25 V | C44 | TICO.K | |
| / | | 220 F 25 V | C45 | TICO.K | |
| 1 | | 0,47 F 63 V | C46 | CN 74 | EUROFARAD |
| / | | 0,1 F 63 V | C49 | CN 73-1 | EUROFARAD |
| / | | 0,1 F 63 V | C50 | CN 73-1 | EUROFARAD |
| / | | 0,1 F 63 V | C51 | CN 73-1 | EUROFARAD |
| / | | 0,1 F 63 V | C55 | CN 73-1 | EUROFARAD |
| / | | 0,1 F 63 V | C56 | CN 73-1 | EUROFARAD |
| 1 | | 330 pF 250V | C57 | CN 19 | |
| | | TRANSISTOR | | | |
| 1 | | | Q2 | BC 327 | MOTOROLA |
| 2 | | | Q3 | BC 337 | MOTOROLA |
| / | | | Q4 | BC 337 | MOTOROLA |
| 1 | | | Q5 | 2N 2905 | MOTOROLA |
| 1 | | | Q6 | TIP 125 | MOTOROLA |
| 1 | | | Q7 | 2N 2907 A | MOTOROLA |
| | | DIODE | | | |
| 1 | | Zener 5,6 V | CR4 | BZX 55C 5V6 | |
| | | Schottky | CR6 | BAT 49 | THOMSON |
| / | | Schottky | CR7 | BAT 49 | THOMSON |
| 1 | | | CR8 | 1 N 4148 | |
| | | Schottky | CR11 | BAT 49 | THOMSON |
| 1 | | Schottky | CR12 | BAT 45 | THOMSON |
| 5 | | | CR13 | 1 N 4003 | THOMSON |
| / | | | CR14 | 1 N 4003 | THOMSON |
| / | | | CR15 | 1 N 4003 | THOMSON |

9

| QTE | CODE | DESIGNATION | REP. | REF. FABRICANT | FABRICANT |
|---|---|---|---|---|---|
| / | | | CR16 | 1 N 4003 | THOMSON |
| 4 | | | CR17 | 1 N 4150 | |
| / | | | CR18 | 1 N 4003 | THOMSON |
| / | | | CR19 | 1 N 4150 | |
| | | | | | |
| | | | | | |
| / | | Schottky | CR20 | BAT 49 | THOMSON |
| 1 | | Zener 3,3 V | CR21 | BZX 55C 3V3 | THOMSON |
| / | | | | 1 N 4150 | |
| / | | | | 1 N 4150 | |
| | | | | | |
| | | | | | |
| | | | | | |
| | | CIRCUIT INTEGRE | | | |
| | | | | | |
| | | | | | |
| 1 | | Ampli double | IC28 | LM 358 | NSC/RTC |
| 1 | | 6 inverseur à trigger de | | | |
| | | Schmitt | IC29 | 74 HC 14 | TEXAX |
| 2 | | Diode de précision 2,5 V | IC30 | LM336 BZ 2,5 | N S C |
| / | | Diode de précision 2,5 V | IC31 | LM336 BZ 2,5 | N S C |
| | | | | | |
| | | | | | |
| 1 | | SELF Bobinée s/Plan | L1 | 88 0693 | C.E.I.S. |
| | | | | | |
| | | | | | |
| 1 | | Batonnet de ferrite | L2 | AP 3x1x435 | R T C |
| | | | | | |
| | | | | | |
| 1 | | Potentiomètre 1 K | R101 | 170 | TRW ou |
| 1 | | Potentiomètre 22 K | R102 | T7 YB | SFERNICE |
| | | | | | |
| 1 | | Batterie d'accumulateur 40 RF 304 | BT1 | 125130 | SAFT |
| | | | | | |
| | | | | | |
| | | | | | |
| | | | | | |
| | | | | | |

| QTE | CODE | DESIGNATION | REP | REF. FABRICANT | FABRICANT |
|-----|------|-------------|-----|----------------|-----------|
| 1 | | Interrupteur | S1 | 25336NA6 | A P R |
| 1 | | Point test mâle | PT3 | 33204161 | |
| | | | | 01530 | COMATEL |
| 1 | | Barrette coudée | J7 | 75168-309 | BERG |
| | | | | 36 ou | |
| | | | | 0334-1-09-44-0 | COMATEL |
| 1 | | Embase 3pts mâle coudée | J8 | 22-12-2031 | MOLEX |
| 0,1m | | Frette de câblage | 1 | 2/840 | GAUDEX |

## PROCESSEUR (Fig.3 à 5)

| | | RESISTANCE | | | | | |
|---|---|---|---|---|---|---|---|
| 9 | | 4,7 K | 2% | 1/8 W | R1 | RC 8 U | |
| / | | 4,7 K | 2% | 1/8 W | R2 | RC 8 U | |
| 5 | | 10 K | 2% | 1/8 W | R3 | RC 8 U | |
| 1 | | 33 K | 2% | 1/8 W | R4 | RC 8 U | |
| / | | 10 K | 2% | 1/8 W | R5 | RC 8 U | |
| | | 5,6 K | 2% | 1/8 W | R6 | RC 8 U | |
| 1 | | 1,5 K | 5% | 1/4 W | R7 | RC 21 U | |
| / | | 4,7 K | 2% | 1/8 W | R8 | RC 8 U | |
| / | | 4,7 K | 2% | 1/8 W | R9 | RC 8 U | |
| / | | 4,7 K | 2% | 1/8 W | R10 | RC 8 U | |
| 1 | | 1 K | 2% | 1/8 W | R19 | RC 8 U | |
| 1 | | 5,6 M | 5% | 1/8 W | R20 | RCMx02K3 | SFERNICE |
| 2 | | 150 K | 2% | 1/8 W | R21 | RC 8 U | |
| / | | 4,7 K | 2% | 1/8W | R22 | RC 8 U | |
| / | | 4,7 K | 2% | 1/8 W | R23 | RC 8 U | |

| QTE | CODE | DESIGNATION | | | REP. | REF. FABRICANT | FABRICANT |
|-----|------|-------------|---|---|------|----------------|----------|
| 7 | | 4,7 K | 2% | 1/8 W | R56 | RC 8 U | |
| 7 | | 4,7 K | 2% | 1/8 W | R57 | RC 8 U | |
| | | | | | | | |
| 7 | | 10 K | 2% | 1/8 W | R59 | RC 8 U | |
| 1 | | 390 | 2% | 1/8 W | R60 | RC 8 U | |
| | | | | | | | |
| 7 | | 10 K | 2% | 1/8 W | R65 | RC 8 U | |
| 7 | | 150 K | 2% | 1/8 W | R66 | RC 8 U | |
| 7 | | 10 K | 2% | 1/8 W | R67 | RC 8 U | |
| 1 | | 10 M | 2% | 1/8 W | R68 | RC 8 U | |
| 2 | | 4,7 K Réseau 8 résistances | | | RR1 | SIL9.8 4,7 K | SFERNICE |
| 7 | | 4,7 K Réseau 8 résistances | | | RR2 | SIL9.8 4,7 K | SFERNICE |
| | | | | | | | |
| | | | | | | | |
| | | CONDENSATEUR | | | | | |
| | | | | | | | |
| 2 | | 22 pf | | 100V | C1 | CE 72-5 | LCC/SPRAGUE |
| 7 | | 22 pf | | 100V | C2 | CE 72-5 | LCC/SPRAGUE |
| | | | | | | | |
| 18 | | 0,1 F | | 63V | C4 | CN 73-1 | EUROFARAD |
| 7 | | 0,1 F | | 63V | C5 | CN 73-1 | EUROFARAD |
| 7 | | 0,1 F | | 63V | C6 | CN 73-1 | EUROFARAD |
| 7 | | 0,1 F | | 63V | C7 | CN 73-1 | EUROFARAD |
| | | | | | | | |
| 7 | | 0,1 F | | 63V | C9 | CN 73-1 | EUROFARAD |
| 7 | | 0,1 F | | 63V | C10 | CN 73-1 | EUROFARAD |
| 7 | | 0,1 F | | 63V | C11 | CN 73-1 | EUROFARAD |
| 7 | | 0,1 F | | 63V | C12 | CN 73-1 | EUROFARAD |
| 7 | | 0,1 F | | 63V | C13 | CN 73-1 | EUROFARAD |
| 7 | | 0,1 F | | 63V | C14 | CN 73-1 | EUROFARAD |
| 7 | | 0,1 F | | 63V | C15 | CN 73-1 | EUROFARAD |
| 7 | | 0,1 F | | 63V | C16 | CN 73-1 | EUROFARAD |
| 7 | | 0,1 F | | 63V | C17 | CN 73-1 | EUROFARAD |
| 7 | | 0,1 F | | 63V | C18 | CN 73-1 | EUROFARAD |
| 7 | | 0,1 F | | 63V | C20 | CN 73-1 | EUROFARAD |
| 7 | | 0,1 F | | 63V | C22 | CN 73-1 | EUROFARAD |

| QTE | CODE | DESIGNATION | REF. | REF. FABRICANT | FABRICANT |
|---|---|---|---|---|---|
| 1 | | 4,7 nF    100V | C32 | CN 72-1 | |
| 2 | | 33 pF    100V | C33 | CE 72-5 | |
| / | | 33 pF    100V | C34 | CE 72-5 | |
| 1 | | 15 pF    100V | C35 | CE 72-5 | |
| 1 | | 0,47  F    100V | C36 | CN 74 | |
| 1 | | 6,8  F    63V | C37 | CTS 27 | |
| | | | | | |
| 1 | | Condensateur céramique HF | C54 | CK 0,5 BX104K | THOMSON |
| | | 0,1  F  50V  10% (pas 5,08) | | | |
| / | | 0,1  F    63V | C55 | CN 73-1 | EUROFARAD |
| / | | 0,1  F    63V | C56 | CN 73-1 | EUROFARAD |
| | | | | | |
| | | DIODE | | | |
| | | | | | |
| | | | R1 | 1 N 4150 | |
| | | | R2 | 1 N 4150 | |
| | | | | | |
| | | | | | |
| 1 | | | R5 | BAT 45 | THOMSON |
| | | | | | |
| 1 | | Schottcky | R9 | BAT 49 | THOMSON |
| 1 | | | R10 | 1 N 4148 | |
| | | | | | |
| | | | | | |
| | | MICROSTRUCTURE | | | |
| | | | | | |
| 1 | | Ampli double | IC2 | LM 358 | NSC/RTC |
| | | | | LM 358 P | TEXAS |
| | | | | CA358 E | R C A |
| 2 | | 8 bascules type LATCH 3états | IC3 | 74 HC 373 | TEXAS |
| | | Décodeur    3/8 | IC4 | 74 HC 138 | TEXAS |
| 1 | | Mémoire  RAM  8 Koctets | IC5 | HM6264LP | HITACHI |
| | | | | --6264-- | TOSHIBAS/ |
| 1 | | Mémoire  EPROM  32 Koctets | IC6 | D 27256 | INTEL |
| | | | | --27C512-- | AMD |
| 1 | | Triple NAND  3 entrées | IC7 | 74 HC 10 | TEXAS |
| 1 | | Décodeur de Clavier | IC8 | 74 C 922 | N S C |
| 1 | | Afficheur 4 lignes | | | |
| | | 16 caractères LCD | IC9 | DMC 16433 | OPTREX    ou |
| | | | | | ou |
| | | | | | |
| 1 | | 4 portes ET  à 2 entrées | IC10 | 74 HC 08 | TEXAS |
| 1 | | 4 portes OU  à 2 entrées | IC11 | 74 HC 32 | TEXAS |
| 1 | | 6 inverseurs | IC13 | 74 HC 14 | TEXAS |

13

| QTE | CODE | DESIGNATION | REP. | REF. FABRICANT | FABRICANT |
|---|---|---|---|---|---|
| 1 | | 4 portes ET à 2 entrées | IC17 | 74 F 08 | FAIRCHILD/ |
| 1 | | Horloge temps réel | IC18 | MC 146818P | MOTOROLA |
| | | | | HD 146818P | HITACHI |
| | | | | 146818 | RCA/UPD |
| 1 | | 8 bascules types latchs états | IC2C | 74 HC 373 | TEXAS |
| 1 | | 4 portes NAND | IC27 | 74 HC 00 | TEXAS |
| 1 | | Microprocesseur | IC28 | MC68HC11A1 | MOTOROLA |
| 1 | | Quartz 8 MHZ | Y1 | HC 18 U | MATEL |
| 1 | | Quartz 32.768 KHZ Résonnant parallèle | Y2 | CU 206 | MATEL |
| | | (1) Autres fabricants : NSC, RCA, ETC, SGS, MOTOROLA | | | |
| 1 | | Support de circuit intégré | 3 | 528 AG 37 D | AUGAT |
| 1 | | Barrette 14 pts | J4 | 386-0395-1-14-44-0 | COMATEL |
| 1 | | Barrette coudée haute 8pts | J5 | 399-0303-1-08-44-0 | COMATEL |
| 1 | | Embase F Sub D 25pts | J6 | 9-167 687-1 | A M P |
| 1 | | Embase 3 pts | J7 | D01EE306MS | F R B |
| 1 | | Boîtier au pas de 2,54 | P8 | 22-01-2035 | MOLEX |
| 3 | | Contact | | 4809 C | MOLEX |
| 2 | | Point de test | PT11 | 332041610530 | COMATEL ou |
| | | | PT14 | 332041610530 | COMATEL ou |
| 1 | | Cavalier | E1 | 3130581000530 | COMATEL |
| 1 | | Câble plat équipé | | VFM12A254-09 | |
| | | | | 005STM2/65801 | |
| | | | | SN | WET FRANCE |
| | | S/PLAN | | 88 0756 | C.E.I.S. |

| CIRCUIT D'ADAPTATION DE SIGNAL (Fig.2) | | | | | |
|---|---|---|---|---|---|
| QTE | CODE | · DESIGNATION | REP. | REF.FABRICANT | FABRICANT |
| | | RESISTANCES | | | |
| 2 | | Potentiomètre 22K 20% | R1 | T93 x B | SFERNICE |
| 2 | | 51K 5% 1/8W | R2 | RC 8 U | |
| / | | 51K 5% 1/8W | R3 | RC 8 U | |
| 1 | | 100 5% 1/8W | R4 | RC 8 U | |
| / | | Potentiomètre 22K 20% | R5 | T93 x B | SFERNICE |
| | | CONDENSATEURS | | | |
| 2 | | 33uF 10V | C1 | 196 D 336 | |
| / | | 33uF 10V | C2 | 196 D 336 | |
| 1 | | 10uF 40V | C3 | CTS 27 | |
| 2 | | 220uF 63V | C4 | CN 19 | |
| / | | 220uF 63V | C5 | CN 19 | |
| | | TRANSFORMATEUR | | | |
| 1 | | 220/ 15V | T1 | 212 012 A | |
| | | CIRCUITS INTEGRES | | | |
| 1 | | Convertisseur RMS/DC | IC1 | AD 736 | A.D. |
| 1 | | Ampli opérationnel | IC2 | LE 351 | N.S. |

## Revendications

1.- Dispositif de mesure de la tension du secteur, caractérisé en ce qu'il comporte des moyens (5) pour établir au moins un seuil de fonctionnement et au moins un seuil de dégagement, des moyens (7) pour mesurer la valeur efficace de la tension du secteur, des moyens (11) pour comparer cette valeur mesurée avec un seuil de fonctionnement programmé, des moyens pour mémoriser la date de l'instant auquel la valeur mesurée devient inférieure ou supérieure au seuil programmé, des moyens pour mesurer la durée pendant laquelle la valeur de tension mesurée reste inférieure ou supérieure à un seuil de dégagement et des moyens pour calculer la valeur moyenne de la tension pendant la durée d'une anomalie, des moyens de comparaison de la durée de l'anomalie à un seuil de durée quand la valeur mesurée franchit le seuil de dégagement dans le sens décroissant ou le seuil de fonctionnement dans le sens croissant et des moyens de calcul de la valeur efficace moyenne du phénomène si la durée mesurée est supérieure au seuil de durée.

2.- Dispositif suivant la revendication 1, caractérisé en ce que les moyens de mesure de la valeur efficace de la tension du secteur comprennent un circuit (5) d'adaptation de signal comprenant un transformateur-abaisseur (20) dont la sortie est connectée à l'entrée d'un circuit (22) convertisseur de tension efficace en tension continue, la sortie dudit circuit convertisseur étant reliée à l'entrée d'un filtre passe-bas (27,28,29 30), la sortie du filtre étant connectée à l'entrée d'un processeur (7) destiné à commander les fonctions de comparaison, de mémorisation, d'incrémentation et de calcul de la valeur efficace.

3.- Dispositif suivant l'une des revendications 1 et 2, caractérisé en ce que les moyens pour mémoriser la date de l'instant auquel la valeur mesurée devient inférieure ou supérieure à un seuil programmé, sont constitués par une mémoire RAM (11) associée au processeur (7).

4.- Dispositif suivant l'une des revendications 1 à 3. caractérisé en ce que les moyens pour mesurer la durée pendant laquelle la valeur de tension mesurée reste inférieure ou supérieure à un seuil de dégagement sont constitués par le processeur (7) associé à une horloge (9).

5.- Dispositif suivant l'une des revendications 1 à 4, caractérisé en ce qu'il comporte en outre des moyens (2,3) d'alimentation du dispositif à partir du secteur et des batteries (4) alimentées en permanence par les moyens d'alimentation et destinées à assurer l'alimentation du dispositif pendant un intervalle de temps prédéterminé en cas de défaillance du secteur.

6.- Dispositif suivant la revendication 5, caractérisé en ce que les moyens d'alimentation comprennent un circuit (50) de production de tensions continues positives et négatives associé à un circuit (51) de protection en sous-tension et en puissance, celui-ci étant destiné à engendrer sur ses sorties (B1, B2) un signal de bon fonctionnement et étant connecté par l'intermédiaire d'un circuit interrupteur (58) à un circuit (57) de production d'une tension régulée, le circuit interrupteur (58) étant commandé en ouverture par le processeur (8) et en fermeture par le signal de bon fonctionnement délivré par le circuit de protection (51).

7.- Dispositif suivant les revendications 5 et 6, caractérisé en ce qu'il comporte une batterie primaire (56), un circuit (55) de charge de la batterie primaire à partir de l'une des tensions continues délivrées par le circuit (50) de production de tensions continues positives et négatives et une batterie secondaire de sauvegarde (62) ainsi qu'un circuit (61) de charge de la batterie secondaire (62) à partir de la tension délivrée par le circuit (57) de production de la tension régulée à partir de la batterie primaire (56) en l'absence de l'alimentation fournie par le circuit (50) de production de tensions continues positives et négatives provoquée par une défaillance du secteur.

8.- Dispositif suivant l'une des revendications 5 à 7, caractérisé en ce qu il comporte en outre un circuit (60) de protection des mémoires du processeur (8) en cas de baisse de la tension délivrée par le circuit (57) de production de la tension régulée, ledit circuit de protection (60) étant en outre destiné à générer un signal de rétablissement pour le processeur (7).

9.- Dispositif suivant la revendication 1, caractérisé en ce que les moyens de calcul de la valeur efficace moyenne lorsque la durée mesurée est supérieure au seuil de durée ne prennent pas en compte quelques demi-périodes au début et à la fin d'une chute de tension.

FIG.1

EP 0 390 680 A1

FIG. 2

EP 0 390 680 A1

BAISSE TENSION PRIMAIRE

31

7

| | 39 | AD 0 | 9 | 44 |
| | 38 | AD 1 | 10 | 45 |
| | 37 | AD 2 | 11 | 46 |
| | 36 | AD 3 | 12 | 47 |
| | 35 | AD 4 | 13 | 49 |
| | 34 | AD 5 | 14 | 49 |
| | 33 | AD 6 | 15 | 50 |
| | 32 | AD 7 | 16 | |
| | 30 | AS | 4 | |
| | 29 | | | |
| | 21 | A 8 | 42 | 43 |
| | 22 | A 9 | 41 | 51 |
| | 23 | A 10 | 40 | 52 |
| | 24 | A 11 | 39 | |
| | 25 | A 12 | 38 | |
| | 26 | A 13 | 37 | |
| | 27 | A 14 | 36 | |
| | 28 | A 15 | 35 | |

IC27

IC28
68HC 11
QUAD PACK

ANO

CARTE
ADAPTATION
SIGNAL

VRL

VRH

Vdd    Vss

XTAL  7
EXTAL  8
RESET/ 17

IC27

RD

E  5

R/WR  6

IC27

IC27

WR

COMMANDE COUPURE AL M    SH2    CARTE ALIM

IT CLAVIER        IC 1  32
IT PERIODIQUE     IRQ  19

T x D  21
R x D  20

HCCA HOO B  55

R 67

+5V      +5V

| IC | +5V | GND | C+5V |
|----|-----|-----|------|
| 27 | 14  | 7   | CS5  |
| 28 | 26  | 1   | CS6  |

FIG. 3

FIG.4

EP 0 390 680 A1

FIG.5

EDF

FIG.6

FIG.7

EDF

89/

FIG.8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 163 282 (SUPERIOR ELECTRIC) * Résumé; page 12, lignes 1-12,24-26; page 16, ligne 21 - page 17, ligne 30; page 19, ligne 20 - page 20, ligne 28; figures 7,9 * | 1,3,4 | G 01 R  19/165 |
| A | --- | 2,5,6,8 | |
| Y | ELEKTRIE, vol. 29, no. 9, septembre 1975, pages 494-495; H. VOLAND: "Ein Gerät zum Klassieren von Spannungsabsenkungen in Elektroenergie-Versorgungssystemen" * Résumé; figure 1; tableaux 1,2 * --- | 1,3,4 | |
| A | US-A-4 713 608 (CATILLER et al.) * Colonne 3, lignes 11-29; figure 1 * --- | 1,2 | |
| A | US-A-4 346 346 (SILBERBERG) * Colonne 1, lignes 6-11; colonne 2, lignes 8-19,46-48; figure 1 * --- | 1,2 | |
| A | FR-A-1 118 532 (ELECTRICITE DE FRANCE) * Colonne de gauche, alinéas 1,2 * ----- | 1 | **DOMAINES TECHNIQUES RECHERCHES (Int. Cl.5)** G 01 R H 01 H |

Le présent rapport a été établi pour toutes les revendications

| Lieu de la recherche | Date d'achèvement de la recherche | Examinateur |
|---|---|---|
| LA HAYE | 20-07-1990 | SINAPIUS G.H. |

EPO FORM 1503 03.82 (P0402)